# EUROPEAN PATENT APPLICATION

(11) **EP 1 607 940 A2**
(43) Date of publication of application: **21.12.2005**
(21) Application number: 05252880.9
(22) Date of filing: 11.05.2005
(51) Int. Cl.: G11B 5/64, G11B 5/66, G11B 5/85, C22C 19/07, C23C 14/20

(54) **Enhanced sputter target alloy compositions**

(30) Priority: 15.06.2004 US 866795
(71) Applicant: Heraeus, Inc., Chandler, AZ 85226 (US)
(72) Inventor: Ziani, Abdelouahab, Chandler, AZ 85226 (US); Kunkel, Bernd, Phoenix, AZ 85048 (US); Cheng, Yuanda R., Phoenix, AZ 85048 (US); Bartholomeusz, Michael, Phoenix, AZ 85045 (US)
(74) Representative: Hill, Justin John

(57) **Abstract**

A sputter target, where the sputter target is comprised of Co, greater than 0 and as much as 24 atomic percent Cr, greater than 0 and as much as 20 atomic percent Pt, greater than 0 and as much as 20 atomic percent B, and greater than 0 and as much as 10 atomic percent *X*₁, where *X*₁ is an element selected from the group consisting of Ag, Ce, Cu, Dy, Er, Eu, Gd, Ho, In, La, Lu, Mo, Nd, Pr, Sm, Tl, W, and Yb. The sputter target is further comprised of *X*₂, wherein *X*₂ is selected from the group consisting of W, Y, Mn, and Mo. Moreover, the sputter target is further comprised of 0 to 7 atomic percent *X*₃, wherein *X*₃ is an element selected from the group consisting of Ti, V, Zr, Nb, Ru, Rh, Pd, Hf, Ta, and Ir. The thin film sputtered by the sputter target has a coercivity value between 1000 Oersted and 4000 Oersted, and is suitable for a magnetic recording medium.

## Description

### FIELD OF THE INVENTION

The present invention relates to sputter targets and, more particularly, relates to magnetic data-storing thin films sputtered from sputter targets which are comprised of alloy compositions with improved metallurgical characteristics.

### DESCRIPTION OF THE RELATED ART

The process of DC magnetron sputtering is widely used in a variety of fields to provide thin film material deposition of a precisely controlled thickness and within narrow atomic fraction tolerances on a substrate, for example to coat semiconductors and/or to form films on surfaces of magnetic recording media. In one common configuration, a racetrack-shaped magnetic field is applied to the sputter target by placing magnets on the backside surface of the target. Electrons are trapped near the sputtering target, improving argon ion production and increasing the sputtering rate. Ions within this plasma collide with a surface of the sputter target causing the sputter target to emit atoms from the sputter target surface. The voltage difference between the cathodic sputter target and an anodic substrate that is to be coated causes the emitted atoms to form the desired film on the surface of the substrate.

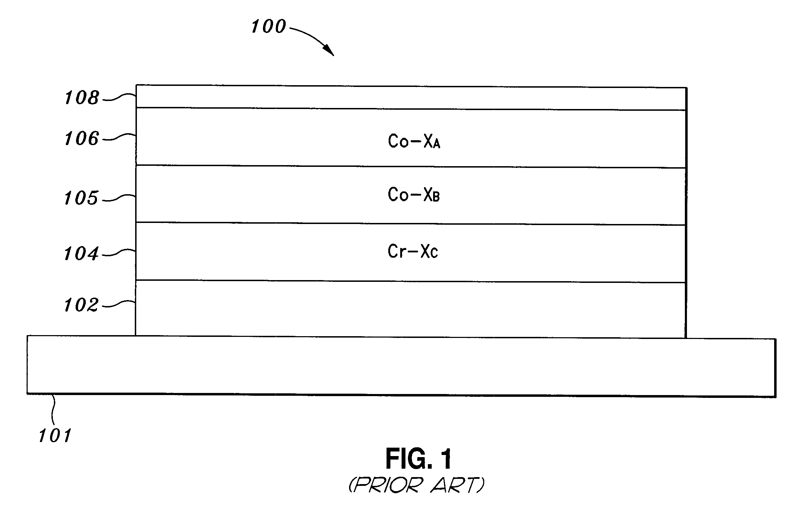

Conventional magnetic recording media typically comprise several thin film layers which are sequentially sputtered onto a substrate by multiple sputter targets, where each sputter target may be comprised of a different material. As illustrated in Figure 1, a typical thin film stack for conventional magnetic recording media includes non-magnetic substrate base 101, seed layer 102, at least one non-magnetic, chromium-based underlayer 104, at least one slightly magnetic, cobalt-based interlayer 105, at least one magnetic data-storing layer 106, and lubricant layer 108.

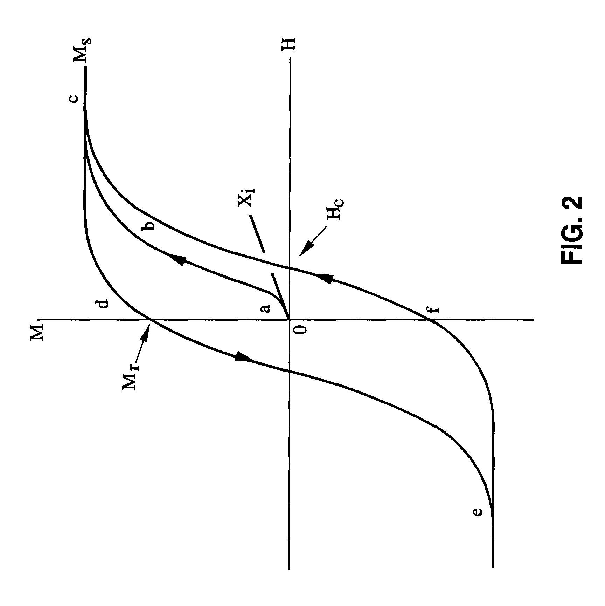

The amount of data that can be stored per unit area on a magnetic recording medium is directly related to the metallurgical characteristics and the composition of the data-storing layer and, correspondingly, to the sputter target material from which the data-storing layer is sputtered. Figure 2 illustrates a typical hysteresis loop of a data-storing thin film layer, obtained by the Vibrating Sample Magnetometer ("VSM") technique. Using this process, a VSM quasi-statically drives a magnet around its hysteresis loop using an applied field from an electromagnet. The sample is vibrated in this field, and the measurement system detects the applied field (H) and the sample's magnetization (M) in the applied field. Figure 2 depicts the variation of material magnetization (M) in the direction of the applied field (H).

Hysteresis parameters include saturation (or maximum) magnetization (Mₛ), zero field remnant magnetization (Mᵣ), coercivity (H_{c}), coercive squareness (S* = 1-(Mᵣ/H_{c})/(dM/dH)) and remanence squareness (S = Mᵣ/Mₛ). Zero field remnant magnetization (Mᵣ) (or "remanence") is a measure of the remaining magnetization when the driving field is dropped to zero, and coercivity (H_{c}) is a measure of the reverse field needed to drive the magnetization to zero after being saturated. These macroscopic properties determine read back signal (So) variables such as pulse shape, amplitude, and resolution.

The predominant materials presently used for conventional magnetic recording media are ferromagnetic, Co-Cr-Pt-B-based alloys, arranged as an array of nanoscale grains where each grain is typically 10 nm or less. The intergranular gap at those grain boundaries is generally very narrow, and the intergranular gap is often not sufficient to prevent magnetostatic and intergranular exchange.

There are three approaches to thin film noise reduction: compositional segregation at grain boundaries, multilayer application, and physical grain separation. Briefly, by applying magnetic multilayers in a stack of ferromagnetic films separated by nonmagnetic thin layers, or by sputtering a thin film at low temperatures and high pressures to generate a "voided grain structure, the noise in magnetic media can be decreased, and data storage capabilities increased.

In either of multilayer application or physical grain separation, the sputtering parameters are very critical in tailoring the physical separation of media grains. Further study of microscopic properties, such as grain size, grain coupling, and grain crystallographic orientation is required to improve upon these techniques to improve the noise performance (N) of the thin films. Furthermore, to produce more optimal magnetic recording media, an optimization of both the macro-magnetics and micro-magnetics is warranted.

As to the third technique for noise reduction, limited success in compositional segregation has been achieved by adding insoluble elements to the Co matrix. As an example, sputtering quaternary alloys such as CoCrPtTa and CoCrPtB has proven to be an effective way of producing low noise media, particularly with thin films containing boron. For boron to be effective in reducing grain coupling, however, the boron content within a CoCrPtB alloy must be in excess of 12 atomic percent. When adding such a high atomic percent of boron, however, the material is rendered very brittle and becomes prone to cracking upon forming, even when processed at high temperatures. As such, high atomic percent boron additions negatively impact material suitability for subsequent thermo-mechanical processing.

It is therefore considered highly desirable to provide a magnetic recording medium with a dense grain structure at the magnetic data-storing layer, to improve the signal-to-noise ratio and increase potential data storage capabilities. In particular, it is desirable to provide alloys such as boron-containing alloys with improved compositional segregation, which can be used in sputter targets and sputtered into thin films with an enhanced composition.

### SUMMARY OF THE INVENTION

Preferred embodiments of the present invention solve the foregoing problems by providing a sputter target for sputtering a magnetic, data-storing thin film layer, where the sputter target is comprised of an alloy composition which effectuates the precipitation of a secondary grain boundary.

According to one aspect, the present invention is a sputter target, where the sputter target is comprised of Co, greater than 0 and as much as 24 atomic percent Cr, greater than 0 and as much as 20 atomic percent Pt, greater than 0 and as much as 20 atomic percent B, and greater than 0 and as much as 10 atomic percent *X*₁, where *X*₁ is an element selected from the group consisting of Ag, Ce, Cu, Dy, Er, Eu, Gd, Ho, In, La, Lu, Mo, Nd, Pr, Sm, Tl, W, and Yb.

The sputter target according to the present invention includes elements selected from transition, refractory and rare-earth groups. These elements are selected on their solid-state immiscibility in Co and/or Cr, and their tendency to combine with Pt to form a stoichiometrically favorable compound formula, in which the compound includes a low fraction of Pt atom and a predominant fraction of the additive element. This condition is critical for maintaining sufficient Pt atom fraction in the Co matrix in order not to sacrifice coercivity. By adding elements, which are insoluble in either cobalt or chromium, the added elements will be rejected from the Co-Pt phase, and will be forced to the grain boundaries, increasing grain separation and, consequently, improving the signal-to-noise ratio.

The sputter target is further comprised of *X*₂, wherein *X*₂ is selected from the group consisting of W, Y, Mn, and Mo. Moreover, the sputter target is further comprised of 0 to 7 atomic percent *X*₃, wherein *X*₃ is an element selected from the group consisting of Ti, V, Zr, Nb, Ru, Rh, Pd, Hf, Ta, and Ir.

The alloys forming the sputter target according to the present invention include compounds, which nucleate and grow at media grain boundaries, providing another type of physical separation of grains. Other additive elements with low diffusivity, such as W and Mo, are expected to provide new nucleation sites, which would allow further grain refinement and promote more Cr segregation to grain boundaries.

The thin film sputtered by the sputter target has a coercivity value between 1000 Oersted and 4000 Oersted. By altering the coercivity to fall within this range, the reverse field needed to drive the magnetization to zero after being saturated can be adjusted to fall within a user's desired parameters. Accordingly the signal-to-noise (S₀/N) ratio will increase, and the overall magnetic properties of thin films intended at high-density magnetic recording will improve. The thin film layer sputtered from the sputter target has a gain of 0.5 dB to in excess of 1.5 dB in the signal-to-noise ratio over a corresponding quaternary CoCrPtB alloy, where a corresponding quaternary CoCrPtB alloy is defined as an alloy with the same atomic percentage for each of Co, Cr, Pt, and B as the Co-Cr-Pt-B-*X*_{*1*} alloy, without the addition of any *X*_{*1*}.

According to a second aspect, the present invention is a magnetic recording medium including a substrate and a data-storing thin film layer formed over the substrate. The data-storing thin film layer is comprised of Co, greater than 0 and as much as 24 atomic percent Cr, greater than 0 and as much as 20 atomic percent Pt, greater than 0 and as much as 20 atomic percent B, and greater than 0 and as much as 10 atomic percent *X*₁, wherein *X*₁ is an element selected from the group consisting of Ag, Ce, Cu, Dy, Er, Eu, Gd, Ho, In, La, Lu, Mo, Nd, Pr, Sm, Tl, W, and Yb.

According to a third aspect, the present invention is a method for manufacturing a magnetic recording medium. The method includes the step of sputtering at least a first data-storing thin film layer over a substrate from a sputter target, where the sputter target is comprised of Co, greater than 0 and as much as 24 atomic percent Cr, greater than 0 and as much as 20 atomic percent Pt, greater than 0 and as much as 20 atomic percent B, and greater than 0 and as much as 10 atomic percent *X*₁, where *X*₁ is an element selected from the group consisting of Ag, Ce, Cu, Dy, Er, Eu, Gd, Ho, In, La, Lu, Mo, Nd, Pr, Sm, Tl, W, and Yb.

In the following description of the preferred embodiment, reference is made to the accompanying drawings that form a part thereof, and in which is shown by way of illustration a specific embodiment in which the invention may be practiced. It is to be understood that other embodiments may be utilized and changes may be made without departing from the scope of the present invention.

### BRIEF DESCRIPTION OF THE DRAWINGS

Referring now to the drawings in which like reference numbers represent corresponding parts throughout:
Figure 1 depicts a typical thin film stack for conventional magnetic recording media;
Figure 2 depicts a typical M-H hysteresis loop of a magnetic material;
Figure 3 depicts a thin film stack in which the magnetic data-storing layer has been sputtered by a sputter target comprised of the enhanced composition according to one embodiment of the present invention;
Figure 4 depicts a Co-Cu phase diagram;
Figure 5 depicts a Cr-Cu phase diagram;
Figure 6 depicts a Cu-Pt phase diagram;
Figure 7 illustrates a typical as-cast microstructure of Co-14Cr-12.5Pt-6Cu-12B at. % alloy; and
Figure 8 illustrates etching pits showing the distribution of Cu₃Pt within the dendritic phase.

### DETAILED DESCRIPTION OF THE INVENTION

Embodiments of the present invention allow for increased data storage of a magnetic recording medium by adding selected fifth and/or sixth constituents to a base CoCrPtB, in order to achieve an optimal composition for the sputter target material.

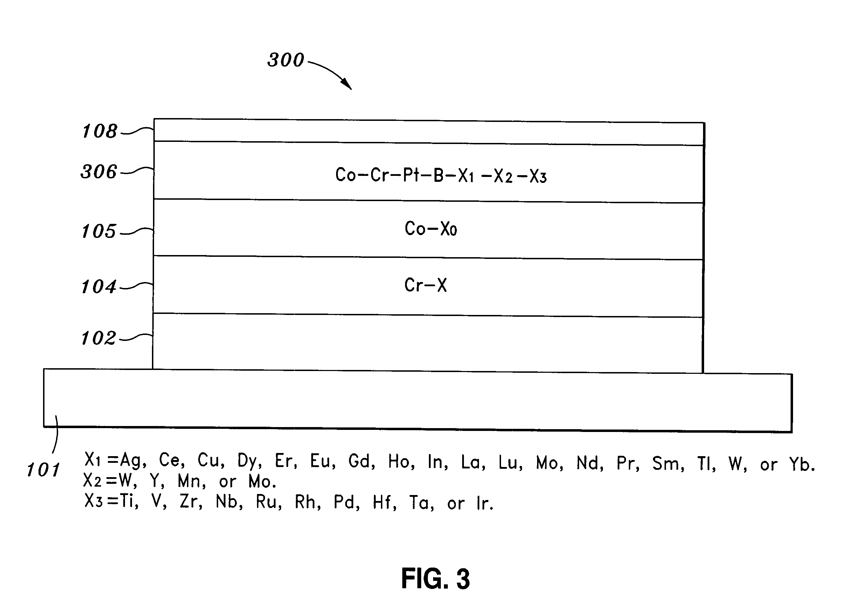

Figure 3 depicts a magnetic recording medium in which the data-storing thin film layer has been sputtered by a sputter target comprised of the enhanced composition according to one embodiment of the present invention. Briefly, the magnetic recording medium includes a data-storing thin film layer comprised of Co, greater than 0 and as much as 24 atomic percent Cr, greater than 0 and as much as 20 atomic percent Pt, greater than 0 and as much as 20 atomic percent B, and greater than 0 and as much as 10 atomic percent *X*₁, where *X*₁ is an element selected from the group consisting of Ag, Ce, Cu, Dy, Er, Eu, Gd, Ho, In, La, Lu, Mo, Nd, Pr, Sm, Tl, W, and Yb.

In more detail, magnetic recording medium 300 includes non-magnetic substrate base 101, seed layer 102, at least one non-magnetic, Cr-based underlayer 104, at least one slightly magnetic, Co-based interlayer 106, data-storing thin film layer 306, and lubricant layer 108. As noted above, data-storing thin film layer on magnetic recording medium 300 is comprised of Co, greater than 0 and as much as 24 atomic percent Cr, greater than 0 and as much as 20 atomic percent Pt, greater than 0 and as much as 20 atomic percent B, and greater than 0 and as much as 10 atomic percent *X*₁, where *X*₁ is an element selected from the group consisting of Ag, Ce, Cu, Dy, Er, Eu, Gd, Ho, In, La, Lu, Mo, Nd, Pr, Sm, Tl, W, and Yb. In an alternate arrangement, magnetic recording medium 300 omits seed layer 102, underlayer 104, interlayer 105, and/or lubricant layer 108.

Magnetic recording medium 300 is manufactured by sputtering data-storing thin film layer 306 over a substrate 101 from a sputter target, where the sputter target is also comprised of Co, greater than 0 and as much as 24 atomic percent Cr, greater than 0 and as much as 20 atomic percent Pt, greater than 0 and as much as 20 atomic percent B, and greater than 0 and as much as 10 atomic percent *X*₁, where *X*₁ is an element selected from the group consisting of Ag, Ce, Cu, Dy, Er, Eu, Gd, Ho, In, La, Lu, Mo, Nd, Pr, Sm, Tl, W, and Yb. The process of sputtering is well known in material science.

The sputter target according to the present invention includes elements selected from transition, refractory and rare earth groups. These elements were selected on their solid-state immiscibility in Co and/or Cr, and their tendency to combine with Pt to form a stoichiometrically favorable compound formula, as discussed more fully below.

The sputter target and corresponding data-storing thin film layer are further comprised of *X*₂, wherein *X*₂ is selected from the group consisting of W, Y, Mn, and Mo. Moreover, the sputter target and corresponding data-storing thin film layer are further comprised of 0 to 7 atomic percent *X*₃, wherein *X*₃ is an element selected from the group consisting of Ti, V, Zr, Nb, Ru, Rh, Pd, Hf, Ta, and Ir. In an additional alternate arrangement, elements *X*₂ and/or *X*₃ are omitted.

By adding elements, which are insoluble in either cobalt or chromium, the added elements will be rejected from the cobalt and chromium phases, and will be forced to the grain boundaries. The alloys forming the sputter target according to the present invention include compounds, which nucleate and grow at media grain boundaries, providing another type of physical separation of grains. Additive elements W and Mo further provide new nucleation sites which allow grain refinement and which promote more Cr segregation to grain boundaries.

By forming alloys with large diameter transition elements, such as Pt, Ta, Ir and Sm, the magnetic data-storing thin film layer sputtered from the sputter target are tailored to have a coercivity value from 1000 Oersted to in excess of 4000 Oersted. By altering the coercivity to fall within this range, the reverse field needed to drive the magnetization to zero after being saturated can be adjusted to fall within a user's desired parameters. Accordingly the signal-to-noise ratio will increase, and the overall magnetic properties of thin films intended at high-density magnetic recording will improve. Microscopic properties, such as grain size, grain coupling, and grain crystallographic orientation, determine the noise performance (N) of thin films, and an optimization of the macro-magnetics and micro-magnetics is necessary to produce the optimum disk.

The first element used in the sputter target according to one aspect of the present invention is cobalt. Cobalt, a key element for most data storage applications, has a low coercivity, and requires the addition of large diameter transition elements such as Pt, Ta, Ir and Sm to form alloys with coercivity values from 1000 Oersted to in excess of 4000 Oersted.

Chromium, a second crucial element for data storage applications, serves two critical purposes within the alloy. First, chromium reduces the corrosion potential in the alloy by oxidizing and passivating the surface of the alloy from further oxidation. Second, the presence of chromium in the magnetic alloy allows for precipitation of other crystalline phases of other elements, such as boron, at grain boundaries or within grains, aiding in noise reduction.

As discussed above, a third element, boron, has been previously used to reduce grain coupling. For boron to be effective in reducing grain coupling, however, the boron content within a CoCrPtB alloy must be in excess of 12 atomic percent, rendering a material very brittle upon forming, even when processed at high temperatures, and making the target material unsuitable for subsequent thermo-mechanical processing. The sputter target according to the present invention, therefore, includes alloy additives, which complement boron's beneficial inter-granular coupling reducing effect, while maintaining acceptable thermo-mechanical alloy workability.

In embodiments of the present invention, selected elements of transition, refractory and rare earth groups are used on the basis of their solid state immiscibility in Co and/or Cr and their possible tendency to combine with Pt to form a stoichiometrically favorable compound formula. These selected elements form a compound formula which comprises a low fraction of Pt atom and a predominant fraction of the additive element, a condition which is critical for maintaining a sufficient Pt atom fraction in the Co matrix, so as to not affect coercivity. The selected elements which fulfill those conditions Ag, Ce, Cu, Dy, Er, Eu, Gd, Ho, In, La, Lu, Mo, Nd, Pr, Sm, Tl, W and Yb.

The above-listed elements form compounds which will nucleate and grow at media grain boundaries, and provide another type of physical separation of grains. Furthermore, other additive elements with low diffusivity, such as W and Mo, provide new nucleation sites, which would allow further grain refinement and promote more Cr segregation to grain boundaries.

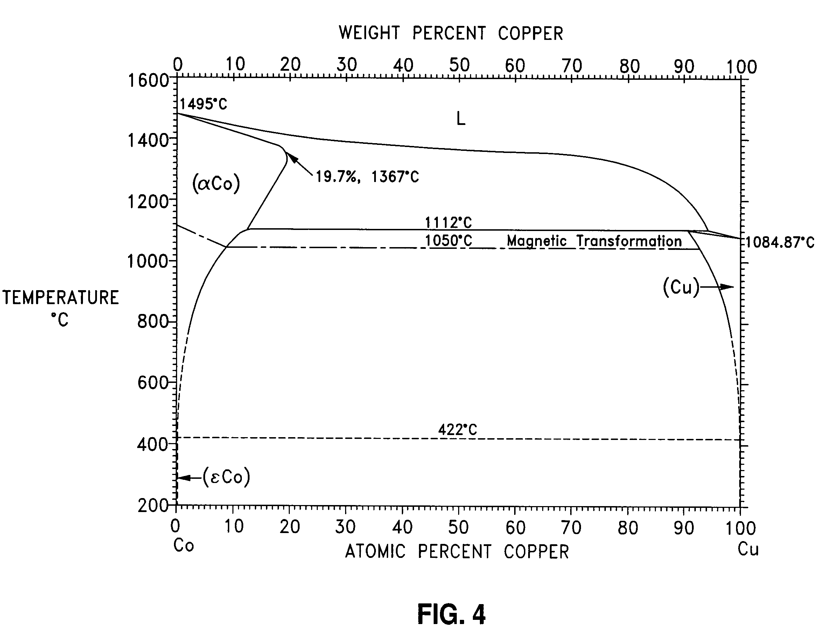

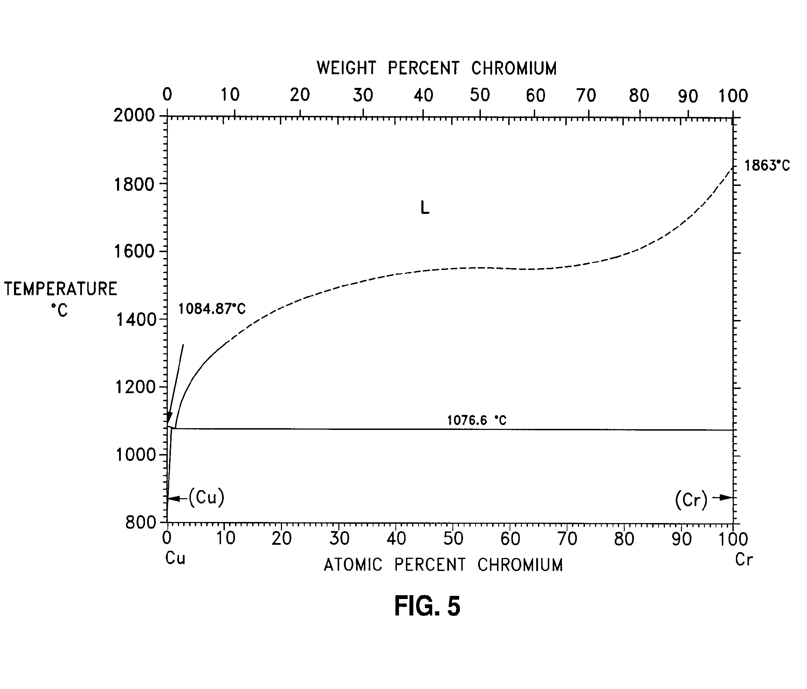

Figures 4 to 6 depict phase diagrams of binary Cu-Co, Cu-Cr and Cu-Pt alloys respectively, illustrating the effect of adding copper as the selected additive. At room temperature, the solvus lines which delimit the extent of (εCo) (Figure 4) and (Cr) (Figure 5) solid solutions domain merges to the temperature axis, indicating that Cu has only a negligible solubility in those solid solutions. As such, Figure 4 and Figure 5 illustrate how the copper additive is rejected by cobalt and chromium, respectively, at room temperatures, and is not absorbed into the Co-Cr grain. Consequentially, the copper additive is forced to the grain boundaries, increasing grain separation and improving the signal-to-noise ratio.

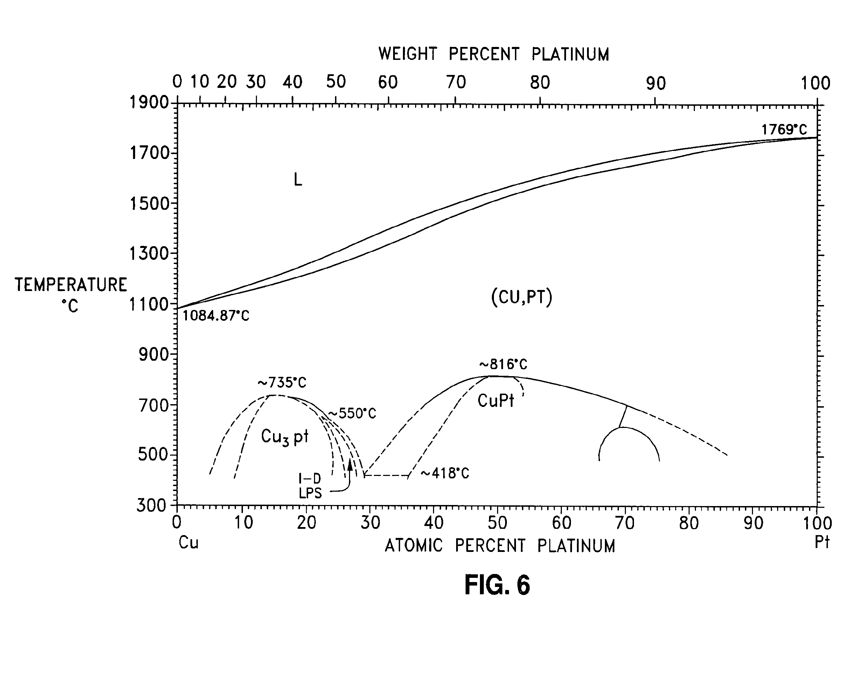

In Figure 6, Cu-Pt phase diagram data depicts the formation of two ordered phases, Cu₃Pt and CuPt. Since Cu₃Pt is a compound formula which comprises a low fraction of Pt atom and a predominant fraction of copper, the most stoichiometrically favorable phase would be Cu₃Pt. If Cu₃Pt is formed, a sufficient Pt atom fraction in the Co matrix is maintained, so as to not affect coercivity.

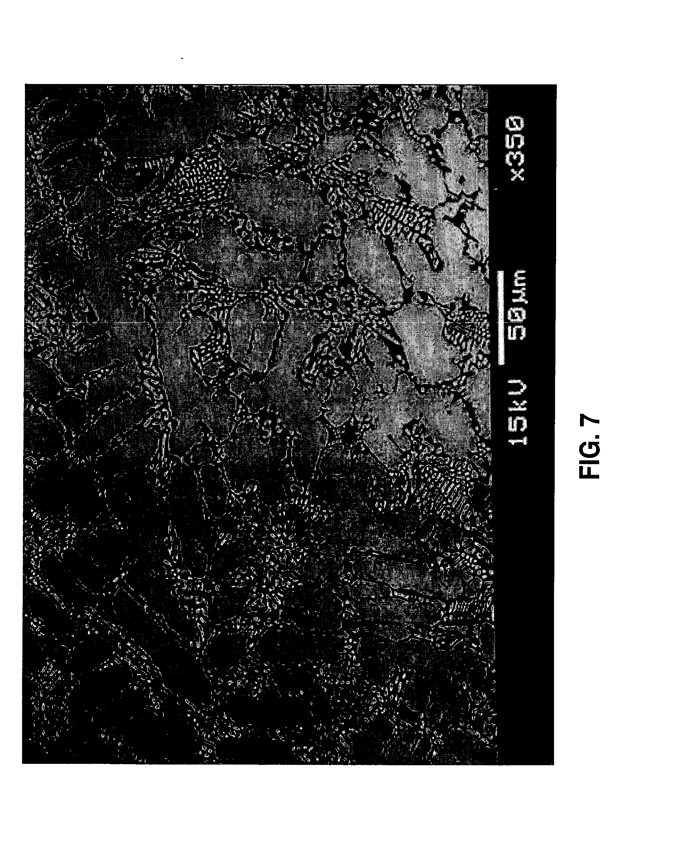

Figure 7 depicts the as-cast microstructure of a Co-14Cr-12.5Pt-6Cu-12B atomic percent alloy. The microstructure consists of a primary dendritic phase (shown as light gray) surrounded by a eutectic matrix (shown as a lamellae-like phase). The dendritic phase is a CoPtCu rich phase with a minor amount of dissolved Cr. The eutectic matrix is substantially a CrCoB phase.

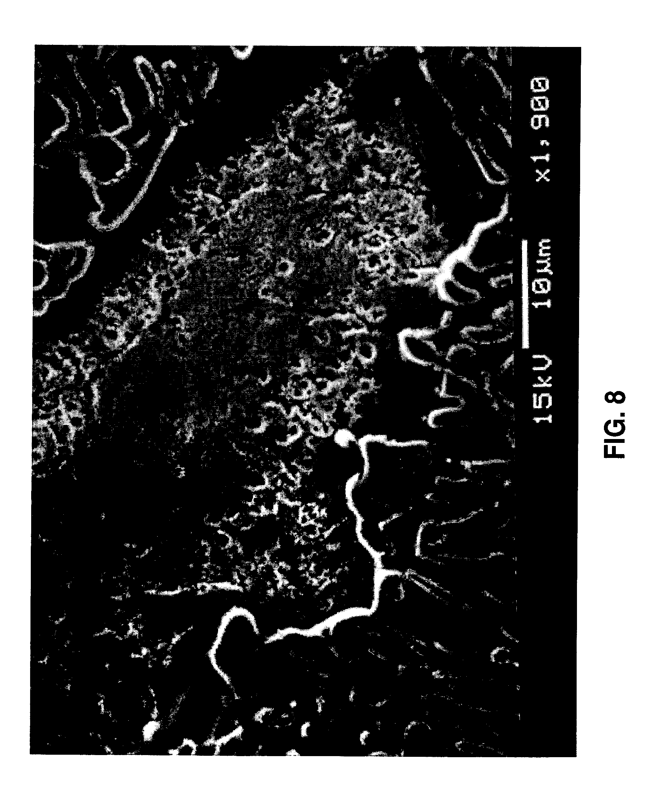

Figure 8 is an SEM micrograph, or back-scattered electron image, of the grain. The contrast in such images originates from the differences in atomic weight of the various phases' constituents. While the dendritic phase appears to be a single phase, a chemically etched sample revealed the presence of another Cu rich phase. In this regard, Figure 8 shows a high magnification image of a dendrite in which "pits" can be distinguished at the grain boundaries, resulting from the preferential erosion of the Cu₃Pt-rich phase upon etching.

By sputtering a magnetic data-storing thin film layer using the sputter target according to the present invention, a gain of 0.5 dB to in excess of 1.5 dB in the signal-to-noise ratio, at optimal H_{c} and Mₛ, has been reported for an alloy comprised of Co-14Cr-12.5Pt-6Cu-12B, and other similar base alloys with various Cu compositions.

According to a second aspect, the present invention is a magnetic recording medium including a substrate and a data-storing thin film layer formed over the substrate. The data-storing thin film layer is comprised of Co, greater than 0 and as much as 24 atomic percent Cr, greater than 0 and as much as 20 atomic percent Pt, greater than 0 and as much as 20 atomic percent B, and greater than 0 and as much as 10 atomic percent *X*₁, wherein *X*₁ is an element selected from the group consisting of Ag, Ce, Cu, Dy, Er, Eu, Gd, Ho, In, La, Lu, Mo, Nd, Pr, Sm, Tl, W, and Yb.

According to a third aspect, the present invention is a method for manufacturing a magnetic recording medium. The method includes the step of sputtering at least a first data-storing thin film layer over a substrate from a sputter target, where the sputter target is comprised of Co, greater than 0 and as much as 24 atomic percent Cr, greater than 0 and as much as 20 atomic percent Pt, greater than 0 and as much as 20 atomic percent B, and greater than 0 and as much as 10 atomic percent *X*₁, where *X*₁ is an element selected from the group consisting of Ag, Ce, Cu, Dy, Er, Eu, Gd, Ho, In, La, Lu, Mo, Nd, Pr, Sm, Tl, W, and Yb.

The invention has been described with particular illustrative embodiments. It is to be understood that the invention is not limited to the above-described embodiments and that various changes and modifications may be made by those of ordinary skill in the art without departing from the spirit and scope of the invention.

## Claims

1. A sputter target, wherein said sputter target is comprised of Co, greater than 0 and as much as 24 atomic percent Cr, greater than 0 and as much as 20 atomic percent Pt, greater than 0 and as much as 20 atomic percent B, and greater than 0 and as much as 10 atomic percent *X*₁, wherein *X*₁ is an element selected from the group consisting of Ag, Ce, Cu, Dy, Er, Eu, Gd, Ho, In, La, Lu, Mo, Nd, Pr, Sm, Tl, W, and Yb.

2. A sputter target according to Claim 1, wherein said sputter target is further comprised of *X*₂, wherein *X*₂ is selected from the group consisting of W, Y, Mn, and Mo.

3. A sputter target according to Claim 1, wherein said sputter target is further comprised of 0 to 7 atomic percent *X*₃, wherein *X*₃ is an element selected from the group consisting of Ti, V, Zr, Nb, Ru, Rh, Pd, Hf, Ta, and Ir.

4. A sputter target according to Claim 3, wherein said sputter target is further comprised of *X*₂, wherein *X*₂ is selected from the group consisting of W, Y, Mn, and Mo.

5. A magnetic recording medium comprising:
a substrate; and
a data-storing thin film layer formed over the substrate,
wherein said data-storing thin film layer is comprised of Co, greater than 0 and as much as 24 atomic percent Cr, greater than 0 and as much as 20 atomic percent Pt, greater than 0 and as much as 20 atomic percent B, and greater than 0 and as much as 10 atomic percent *X*₁, wherein *X*₁ is an element selected from the group consisting of Ag, Ce, Cu, Dy, Er, Eu, Gd, Ho, In, La, Lu, Mo, Nd, Pr, Sm, Tl, W, and Yb.

6. A magnetic recording medium according to Claim 5, wherein said data-storing thin film layer is further comprised of *X*₂, wherein *X*₂ is selected from the group consisting of W, Y, Mn, and Mo.

7. A magnetic recording medium according to Claim 5, wherein said data-storing thin film layer is further comprised of 0 to 7 atomic percent *X*₃, wherein *X*₃ is an element selected from the group consisting of Ti, V, Zr, Nb, Ru, Rh, Pd, Hf, Ta, and Ir.

8. A magnetic recording medium according to Claim 7, wherein said data-storing thin film layer is further comprised of *X*₂, wherein *X*₂ is selected from the group consisting of W, Y, Mn, and Mo.

9. A magnetic recording medium according to Claim 5, wherein said data-storing thin film layer has a coercivity value between 1000 Oersted and 4000 Oersted.

10. A magnetic recording medium according to Claim 5, wherein said data-storing thin film layer has a gain of at least 1.5 dB in the signal-to-noise ratio over a corresponding quaternary CoCrPtB alloy.

11. A method for manufacturing a magnetic recording medium, comprising the step of sputtering at least a first data-storing thin film layer over a substrate from a sputter target, wherein the sputter target is comprised of Co, greater than 0 and as much as 24 atomic percent Cr, greater than 0 and as much as 20 atomic percent Pt, greater than 0 and as much as 20 atomic percent B, and greater than 0 and as much as 10 atomic percent *X*₁, wherein *X*₁ is an element selected from the group consisting of Ag, Ce, Cu, Dy, Er, Eu, Gd, Ho, In, La, Lu, Mo, Nd, Pr, Sm, Tl, W, and Yb.

12. A method for manufacturing a magnetic recording medium according to Claim 11, wherein the sputter target is further comprised of *X*₂, wherein *X*₂ is selected from the group consisting of W, Y, Mn, and Mo.

13. A method for manufacturing a magnetic recording medium according to Claim 11, wherein the sputter target is further comprised of 0 to 7 atomic percent *X*₃, wherein *X*₃ is an element selected from the group consisting of Ti, V, Zr, Nb, Ru, Rh, Pd, Hf, Ta, and Ir.

14. A method for manufacturing a magnetic recording medium according to Claim 13, wherein the sputter target is further comprised of *X*₂, wherein *X*₂ is selected from the group consisting of W, Y, Mn, and Mo.
